# EUROPEAN PATENT SPECIFICATION

(11) **EP 0 577 080 B1**
(45) Date of publication and mention of the grant of the patent: **02.04.1997**
(21) Application number: 93110372.5
(22) Date of filing: 29.06.1993
(51) Int. Cl.: H05K 13/08, H01L 21/00

(54) **Inspection method of inclination of an IC-package**
Verfahren zur Überprüfung der Neigung eines Gehäuses eines integrierten Schaltkreises
Méthode d'inspection de l'inclinaison d'un boîtier de circuit intégré

(30) Priority: 29.06.1992 JP 194920/92
(43) Date of publication of application: 05.01.1994
(73) Proprietor: YOZAN INC., Tokyo 155 (JP)
(72) Inventor: Matsumoto, Koji, c/o Ezel Inc., Bunkyo-ku, Tokyo 112 (JP)
(74) Representative: Grünecker, Kinkeldey, Stockmair & Schwanhäusser Anwaltssozietät

(56) References cited:
- EP-A- 0 062 335
- EP-A- 0 222 072
- EP-A- 0 374 848

## Description

### FIELD OF THE INVENTION

The present invention relates to a method for determining an inclination of an IC-package.

### BACKGROUND OF THE INVENTION

To mount an IC-package on the predetermined position on a board, it is necessary to set an exact position of the IC-package. In order to find exact position of the IC-package , it is necessary to check a center of the IC-package and its angle of the inclination. In the case extracting the center of the IC-package and its angle of the inclination according to an image processing, the extraction is processed according to a binarized image in order to make the processing speed to be high in the most cases. However, the binarized image is easily damaged by a change of degree of brightness of lights, and it has trouble of a precise guarantee in measuring value.

EP-A-0 222 072 describes a method for automatically loading an IC-package to a printed circuit board by visual positioning. The proposed positioning method includes the step of generating a density projection of the pins of the IC-package for each side of the IC-package. In order to extract the edges of the pins out of the density distribution it is proposed in regard to Figure 10a, to determine the X-coordinates where the projections of the pins have a brightness equal to a predetermined threshold. Since it may happen that the illumination of the pins and thus the obtained brightness is not uniform, it is proposed in connection with Figure 10c to consider the gradient of the brightness distribution and to consider the locations of the highest gradients to correspond to locations of edges. After the edge-coordinates have been found, mean values U1, U2, V1 and V2 are calculated for the four sides of the chip. Finally, opposite mean values are connected by a straight line, as explained in connection with Figures 7a and 7b. In accordance with the embodiment of Figure 7a, the inclination of the chip is represented by the bi-sector of the two connecting lines and according to Figure 7b the inclination is determined by determining angle between the connecting line of two opposite mean values and a fixed line.

It is the object of the present invention to provide a method for determining inclination of an IC-package which is simple and highly accurate.

This object is solved by the subject matter of claim 1.

### BRIEF DESCRIPTION OF DRAWINGS

Figure 1 is a flow chart showing an embodiment of the present invention.

Figure 2 is a conceptual diagram showing a setting of a checking area.

Figure 3 is a conceptual diagram showing a point corresponding to a density projection, a primary differential and each pin of a checking area.

Figure 4 is a diagram for explaining a position of an edge of a subpixel unit.

Figure 5 is a conceptual diagram showing a center of an IC-package.

### PREFERRED EMBODIMENT OF THE PRESENT INVENTION

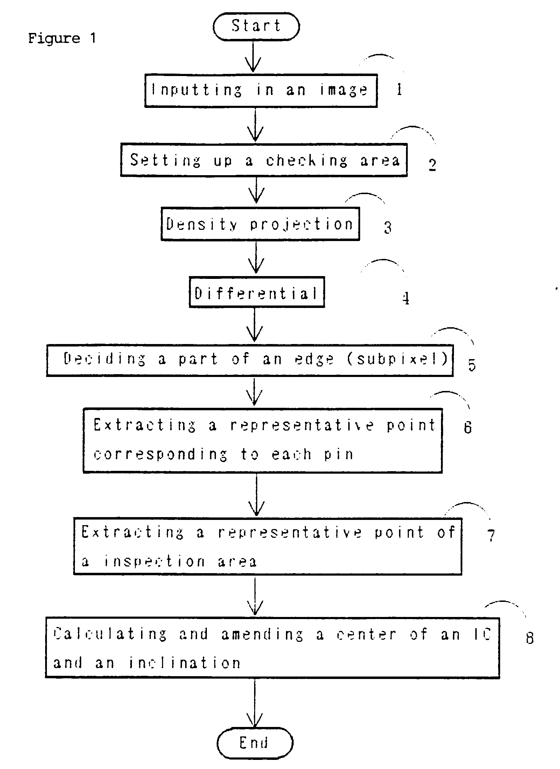

Hereinafter, an embodiment of an inspection method of an inclination of an IC-package of the present invention is described with reference to the attached drawings. Figure 1 is a flow chart showing an embodiment of the present invention.

First, an image of an IC-package with pins on 4 sides of QFT type etc. is taken on step 1. The value of density of the background and that of pin part have difference.

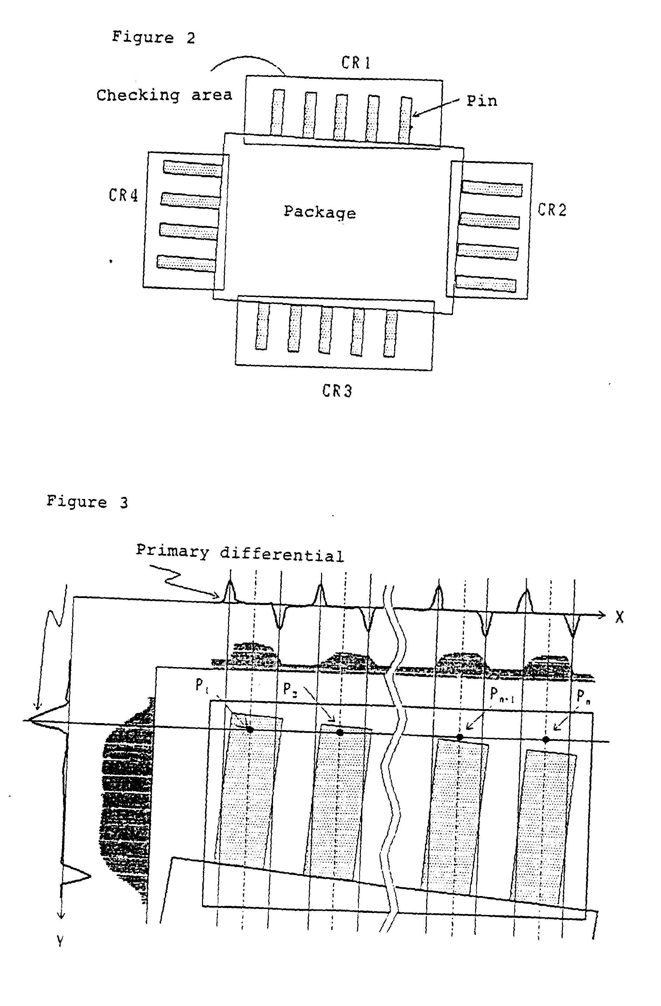

On step 2, checking ranges are set on the predetermined position in the image of the IC-package and defines each of them as CR1 to CR4 (Figure 2). One checking area is set in each side of the IC-package , and there must be open ends of the pins of the IC-package.

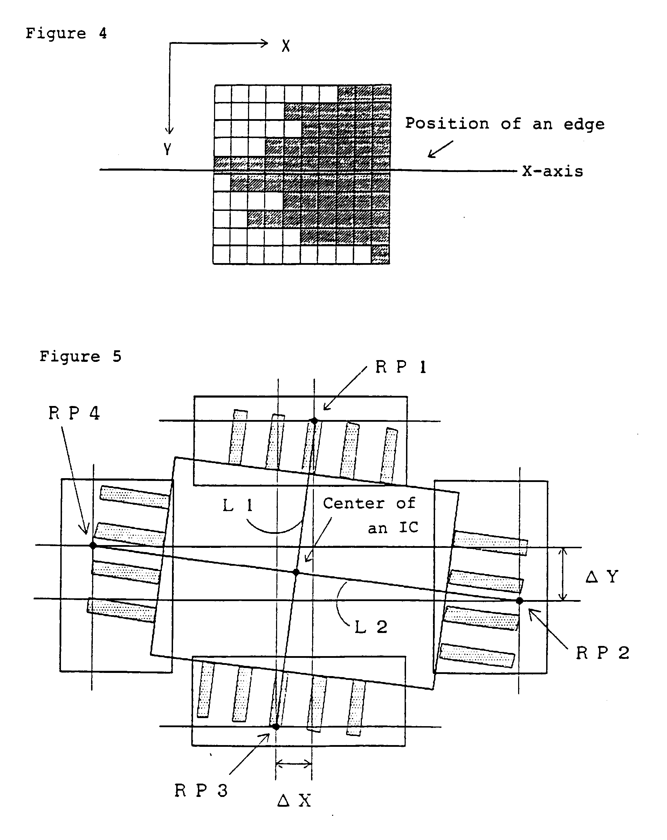

A density projection of directions of X-axis and Y-axis of a checking area is generated on step 3. Figure 3 shows a density projection of a checking area CR1, which is an example. The density projection is data integrated multi-valued information of gray level of an image. The density projection has highly reliable information comparing with a binarized image lacking information on information compression.

On step 4, primary differential is performed for the density projection generated on step 3. Figure 3 shows the differential result by a thick line. As the result, a line along longitudinal edges of the pins is emphasized, that is, the part to be emphasized is a boundary part of X-axis direction and a line along the open ends of the pins, in other words, it is a boundary part of Y-axis direction (A boundary point is expressed by an "edge" hereafter.).

On step 5, a position of an edge is extracted by a subpixel unit, where a coordinate exists between subpixels. Figure 4 shows a part of the edge by a pixel unit of an image in a direction of Y-axis. It is usual that there are uneven in an image as Figure 4. In order to calculate more accurate position of the edge, that is Y-coordinates from such an image data, subpixels must be considered. As a result, it is possible to obtain more exact and precise Y-coordinates (Figure 4 shows a line of X-axis of the coordinates.) than the method obtaining coordinates by a pixel unit with the maximum value of a primary differential. The coordinates of a direction of X-axis is also calculated by a subpixel unit.

In order to extract a part of an edge, the predetermined value calculated in experience is set as a threshold value, and a part is defined as an edge in the case the primary differential value is over the threshold value. In order to unify a setting method of threshold value, it is better to perform normarization after primary differential.

On step 6, a point corresponding to each pin is extracted. The point is represented by a cross point of a broken line showing a central point of a position of longitudinal edges of each pin and a thick line showing a position of an open edge of each pin as in Figure 3. The cross points are defined by P1 to Pn in the figure.

On step 7 in Figure 3, a mean of a X-coordinates of points from P1 to Pn corresponding to each pin is calculated on X-axis, and it is defined as a representative point RP1 of a checking area CR1.

Each representative point is calculated in all checking areas as above. They are shown by RP1 to RP4 in Figure 5.

Next, on step 8 as shown in Figure 5, lines connecting representative points positioning in the opposite side are calculated and defined as L1 and L2. Then, a crossing point of the lines is defined as a central point of the IC-package. An inclined angle can be calculated according to ΔY/ΔX when a difference of X-coordinates of RP1 and RP3 is defined as ΔX and a difference of a Y-coordinates of RP2 and RP4 is defined as ΔY.

It is possible to calculate an inclined angle in high speed by the present invention because the checking area is small on the predetermined position and the necessary time for the processings is short.

The IC is rotated by the inclined angle defining the calculated center of the IC-package as the center of it and its inclination is amended.

The present invention mentioned above can exactly extract the inclination of an IC-package precisely in high speed without the information of binarized image, and amend the inclination after the extraction easily.

## Claims

1. Method for determining an inclination of an IC-package with respect to a predetermined position comprising the steps of:
generating an image of the IC-package (1),
defining a plurality of inspection areas including open ends of a plurality of pins (2) of the IC-package,
for each inspection area generating a density projection along a first axis of the inspection area (3),
generating a density projection along a second axis of the inspection area, said second axis being orthogonal to the first axis (3),
differentiating the two density projections for each inspection area and determining locations where the differential exceeds a predetermined value in order to determine for each pin within the respective inspection area, a representative point of the open ends defined in respect to the first and second axis (4),
determining for each inspection area a mean representative point, having in respect to the first axis the same co-ordinate as the respective representative points and having, in regard to the second axis, a co-ordinate which constitutes a mean value of the co-ordinates of the respective representative points (6,7), and
calculating the inclination of the IC-package with respect to the first and second axis based on the deviation of mean representative points from inspection areas arranged at opposite sides of the IC-package with respect to the second axis (8).

## Patentansprüche

1. Verfahren zum Bestimmen der Neigung eines IC-Gehäuses bezüglich einer vorgegebenen Position, mit folgenden Schritten:
Erzeugen eines Bildes des IC-Gehäuses (1),
Definieren einer Vielzahl von Überprüfungsbereichen, welche offene Enden einer Vielzahl von Pins (2) des Gehäuses enthalten,
Erzeugen für jeden Überprüfungsbereich einer Dichteprojektion entlang einer ersten Achse des Überprüfungsbereiches (3),
Erzeugen einer Dichteprojektion entlang einer zweiten Achse des Überprüfungsbereiches, wobei die zweite Achse orthogonal zu der ersten Achse (3) ist,
Differenzieren der zwei Dichteprojektionen für jeden Überprüfungsbereich und Bestimmen der Orte, wo das Ergebnis einen vorgegebenen Wert überschreitet, um für jeden Pin innerhalb des entsprechenden Überprüfungsbereichs einen repräsentativen Punkt der offenen Enden in Bezug auf die erste und zweite Achse (4) zu bestimmen,
Bestimmen eines repräsentativen Hauptpunktes für jeden Überprüfungsbereich, der bezüglich der ersten Achse die gleiche Koordinate aufweist wie die entsprechenden repräsentativen Punkte und der bezüglich der zweiten Achse eine Koordinate aufweist, die einen Mittelwert aus den Koordinaten der entsprechenden repräsentativen Punkte (6, 7) darstellt, und
Berechnen der Neigung des IC-Gehäuses bezüglich der ersten und zweiten Achse basierend auf der Abweichung der repräsentativen Hauptpunkte von Überprüfungsbereichen, die auf gegenüberliegenden Seiten des EC-Gehäuses liegen, bezüglich der zweiten Achse (8).

## Revendications

1. Méthode pour déterminer l'inclinaison d'un boîtier de circuit intégré par rapport à une position prédéterminée comprenant les étapes consistant à :
- générer une image du boîtier de circuit intégré (1),
- définir une pluralité de zones d'inspection incluant des extrémités libres d'une pluralité de broches (2) du boîtier de circuit intégré,
- pour chaque zone d'inspection, générer une projection de la densité le long d'un premier axe de la zone d'inspection (3),
- générer une projection de la densité le long d'un deuxième axe de la zone d'inspection, ledit deuxième axe étant orthogonal au premier axe (3),
- différentier les deux projections des densités pour chaque zone d'inspection et déterminer des emplacements où la différentielle excède une valeur prédéterminée afin de déterminer, pour chaque broche dans la zone d'inspection respective, un point représentatif des extrémités libres défini par rapport aux premier et deuxième axes (4),
- déterminer pour chaque zone d'inspection un point représentatif moyen, ayant par rapport au premier axe la même coordonnée que les points représentatifs respectifs et ayant, par rapport au deuxième axe, une coordonnée qui constitue une valeur moyenne des coordonnées des points représentatifs respectifs (6,7), et
- calculer l'inclinaison du boîtier de circuit intégré par rapport aux premier et deuxième axes en fonction de l'écart de points représentatifs moyens provenant de zones d'inspection disposées à des côtés opposés du boîtier de circuit intégré par rapport au deuxième axe (8).
